# FASCICULE DE BREVET EUROPEEN

(11) **EP 1 042 818 B1**
(45) Date de publication et mention de la délivrance du brevet: **14.06.2006**
(21) Numéro de dépôt: 98962496.0
(22) Date de dépôt: 17.12.1998
(51) Int. Cl.: H01L 29/788, H01L 29/51

(54) **Dispositif de mémoire multiniveaux à blocage de Coulomb et méthodes correspondantes de fabrication et d'opération**
Coulomb-Blockade-Mehrpegelspeicheranordnung und entsprechende Herstellungs- und Betriebsverfahren
Coulomb blockade multilevel memory device and corresponding methods of making and operating the same

(30) Priorité: 19.12.1997 FR 9716157
(43) Date de publication de la demande: 11.10.2000
(73) Titulaire: COMMISSARIAT A L'ENERGIE ATOMIQUE, 75015 Paris (FR)
(72) Inventeur: GAUTIER, Jacques, F-38500 Coublevie (FR); PALUN, Lionel, F-38000 Grenoble (FR)
(74) Mandataire: Weber, Etienne Nicolas
(86) Numéro de dépôt international: PCT/FR1998/002768
(87) Numéro de publication internationale: WO 1999/033120

(56) Documents cités:
- EP-A- 0 081 626
- EP-A- 0 750 353
- FR-A- 2 112 241
- D.J. DI MARIA ET AL.: "Electrically-alterable read-only-memory using Si-rich SiO2 injectors and a floating polycristalline silicon storage layer" JOURNAL OF APPLIED PHYSICS., vol. 52, no. 7, juillet 1981, pages 4825-4842, XP002075073 NEW YORK US
- LAIBOWITZ R B ET AL: "CHARGE STORAGE ON SMALL METAL PARTICLES" APPLIED PHYSICS LETTERS, vol. 18, no. 7, 1 avril 1971, pages 267-269, XP002011720
- TIWARI S ET AL: "A SILICON NANOCRYSTALS BASED MEMORY" APPLIED PHYSICS LETTERS, vol. 68, no. 10, 4 mars 1996, pages 1377-1379, XP000582303 cité dans la demande

## Description

### Domaine technique

La présente invention concerne un dispositif de mémoire multiniveaux à blocage de Coulomb ainsi que son procédé de fabrication. Elle concerne également des procédés de lecture, d'écriture et d'effacement d'un réseau de points mémoires comprenant de tels dispositifs de mémoire.

Les mémoires multiniveaux à blocage de Coulomb sont des dispositifs quantiques faisant appel à des îlots conducteurs ou semi-conducteurs sur lesquels peuvent être accumulés des charges électriques.

Le phénomène de blocage de Coulomb se produit dans les îlots conducteurs ou semi-conducteurs, à la fois isolés électriquement de leur environnement et faiblement couplés à celui-ci par effet tunnel. La mise en oeuvre de ce phénomène à des températures proches de la température ambiante requiert que la capacité totale de chaque îlot soit de l'ordre de l'atto farad. Les dimensions des îlots sont de l'ordre du nanomètre.

Les mémoires sont appelées mémoires multiniveaux lorsqu'elles permettent de stocker des niveaux de charge plus ou moins importants bien distincts les uns des autres et ainsi de conserver une information codée sur plusieurs bits. Elles se distinguent des mémoires traditionnelles dans lesquelles l'information conservée est du type tout ou rien. En exploitant le fait que les charges soient réparties sur des îlots conducteurs, les mémoires à blocage de Coulomb sont adaptées au stockage sur plusieurs niveaux.

L'invention trouve des applications dans la réalisation de réseaux de mémoires de très faible dimension, fortement intégrés et de grande capacité.

### Etat de la technique antérieure

L'ensemble des documents cités dans le texte qui suit sont repérés avec une référence numérique. Les références complètes de ces documents sont indiquées à la fin de la description.

Un des premiers dispositifs connus de mémoire à blocage de Coulomb est décrit dans le document (1). Ce dispositif, prévu pour fonctionner à température ambiante, présente une structure de transistor à effet de champ avec un canal de lecture en silicium polycristallin reliant une source à un drain. Lors de la mémorisation, des électrons sont stockés sur des grains conducteurs nanométriques de la couche de silicium polycristallin du canal.

Le document (2) décrit une mémoire à blocage de Coulomb plus classique dont la structure est très proche de celle des mémoires de type EPROM à grille flottante (Erasable Programmable Read Only Memory). Cette mémoire se distingue toutefois des mémoires EPROM par le fait que la grille de la mémoire est remplacée par un ensemble de grains conducteurs de silicium ou de germanium agencés selon un plan.

De plus, l'écriture de données dans une telle mémoire n'est pas effectuée par l'injection de porteurs chauds au voisinage du drain, mais par une injection de porteurs dans les grains par effet tunnel à partir de l'ensemble du canal.

Un dispositif décrit dans les documents (3) et (4) concerne également des mémoires à blocage de Coulomb avec une structure très proche de celle des mémoires EPROM classiques. Dans ces mémoires la grille flottante est suffisamment étroite pour se comporter comme un unique grain de stockage de charge.

Dans les dispositifs décrits ci-dessus, le phénomène de blocage de Coulomb est obtenu grâce à la présence d'un ou plusieurs grains ou îlots de matériau conducteur (ou semi-conducteur) présentant des dimensions de l'ordre du nanomètre. Pour une tension donnée, appliquée à la grille du dispositif, le phénomène de blocage de Coulomb détermine le nombre maximum d'électrons stockés dans chaque îlot. L'effet de mémoire résulte principalement de propriétés de barrière de potentiel d'un matériau diélectrique qui enrobe les grains.

Lorsqu'un couplage par effet tunnel entre le canal des structure décrites, et le ou les grain(s) conducteur(s) est trop fort, les porteurs injectés lors d'une phase d'écriture risquent de retourner vers le canal lorsque le champ électrique qui a servi à les injecter est supprimé.

On rappelle que dans un dispositif de mémoire classique, de type EPROM, la barrière énergétique existant entre la grille flottante et le canal est suffisamment élevée pour garantir le maintien des charges stockées pendant une durée de l'ordre de dix ans.

Le document (5) décrit un dispositif, que l'on peut qualifier de piège à électrons, qui permet de retenir des charges autrement que par une forte barrière de potentiel. Le dispositif du document (5) présente une structure à blocage de Coulomb constituée par la mise en série d'un condensateur et d'au moins deux jonctions tunnel. Une telle structure ne peut toutefois pas être utilisée comme mémoire. En effet, elle ne possède que deux électrodes et est ainsi dépourvue de fonctions de conversion d'impédance et d'adressage.

Il est possible, comme le suggèrent les documents (6) et (7) d'adjoindre à un dispositif de piège à électrons un électromètre pour lire l'information stockée. Une telle solution conduit cependant à un dispositif dont l'encombrement est particulièrement important ; ce qui est incompatible avec les impératifs de miniaturisation et d'augmentation de la densité d'intégration.

Le document (11) montre une structure de mémoire dans laquelle des îlots de Si sont inclus dans une couche de SiO₂. Les îlots de silicium ne sont toutefois pas répartis uniformément entre des grilles. Une zone dépourvue d'îlots sépare deux zones pourvues d'îlots.

Le document (12) montre également une structure de mémoire à injection d'électrons avec une zone de SiO₂ enrichie en Si. Le silicium n'est cependant pas répartis en îlots.

### Exposé de l'invention

La présente invention a pour but de proposer un dispositif de mémoire à blocage de Coulomb ne présentant pas les limitations des dispositifs décrits ci-dessus.

Un but est en particulier de proposer des éléments de mémoire occupant une surface particulièrement réduite sur le substrat sur lequel elles sont réalisées.

Un but est aussi de proposer de tels éléments de mémoire permettant chacun de mémoriser des informations sur plusieurs bits.

Un but est encore de proposer un procédé de réalisation d'un dispositif de mémoire multiniveaux à blocage de Coulomb.

Un but est enfin de proposer un réseau de points mémoires et des procédés d'écriture, de lecture et d'effacement de ces mémoires.

Pour atteindre ces buts, l'invention a plus précisément pour objet un dispositif de mémoire comprenant une structure de transistor MOSFET avec une grille flottante et une grille de commande. Conformément à l'invention, la grille flottante et la grille de commande sont séparées uniquement par un diélectrique incluant une pluralité d'îlots nanométriques conducteurs, séparés les uns des autres.

On entend par îlots nanométriques conducteurs des grains, des cristaux ou des amas d'atomes d'un matériau conducteur électrique tel qu'un métal ou d'un matériau semi-conducteur.

A titre d'exemple, les îlots peuvent être des cristaux de silicium.

Les îlots conducteurs sont isolés les uns des autres par le matériau diélectrique. Ils présentent des dimensions réduites comprises, par exemple, entre 1 nm et 10 nm. La distance entre deux îlots, mesurée perpendiculairement aux grilles, est choisie suffisamment faible pour permettre un courant tunnel de la charge de la mémoire. Ainsi, bien que les îlots soient physiquement séparés, une conduction électrique par effet tunnel est possible mutuellement entre les îlots et entre les îlots et les grilles.

Conformément à l'invention, les îlots forment une structure tridimensionnelle d'îlots répartis uniformément dans tout le diélectrique entre la grille flottante et la grille de commande. Ils permettent ainsi un effet tunnel direct entre les deux grilles, en contrôlant le passage des électrons. (un à un) par un effet de blocage de Coulomb.

Une telle structure permet d'obtenir un bon couplage électrostatique entre la grille de commande et la grille flottante, sans perte de densité d'intégration, compte tenu du fait que les surfaces en regard sont de l'ordre de grandeur de la surface du canal du transistor, par exemple MOSFET.

Selon une réalisation particulière du dispositif, le diélectrique peut comporter des couches superposées de matériau isolant électrique entre lesquels sont disposés des grains métalliques qui forment les îlots conducteurs.

Le diélectrique peut aussi comporter alternativement des couches de silice (SiO₂) et des couches de silice comprenant des monocristaux de silicium ou de germanium, ces monocristaux formant les îlots conducteurs.

L'invention concerne également un procédé de fabrication d'un dispositif de mémoire tel que décrit ci-dessus comprenant, dans l'ordre, les étapes suivantes :
a) formation dans un substrat d'une région de canal,
b) formation d'une couche d'oxyde de grille s'étendant au-dessus de la region de canal,
c) formation sur la couche de diélectrique de grille d'un empilement comportant dans l'ordre à partir de la couche d'oxyde de grille :
   - une première couche de grille,
   - une structure tridimensionnelle d'îlots nanométriques conducteurs, uniformément répartis dans tout un diélectrique
   - une deuxième couche de grille, les première et deuxième couches de grille étant séparées l'une de l'autre uniquement par ce diélectrique incluant les îlots nanométriques conducteurs
d) mise en forme de l'empilement en laissant subsister l'empilement au-dessus d'au moins une portion de la région de canal,
e) formation de régions de source et de drain auto-alignées sur l'empilement mis en forme.
   La couche de diélectrique de grille de l'étape c) peut être par exemple une couche d'oxyde de grille.
   Par ailleurs, dans ce procédé, l'ordre des étapes a) et b) peut être éventuellement interverti. Par ailleurs, lors de la gravure de l'étape d), la couche d'oxyde de grille peut servir de couche d'arrêt de gravure. De plus, lorsque la formation de la région de canal a lieu par dopage, l'implantation des impuretés de dopage peut avantageusement avoir lieu à travers une couche d'oxyde sacrificiel.
   Le procédé peut en outre être complété par la formation de prises de connexion sur les régions de source et de drain et sur la deuxième couche de grille de l'empilement mis en forme.
   L'invention a encore pour objet un réseau de points mémoire comportant une pluralité de dispositifs de mémoire, tels que décrits précédemment, qui forment les points mémoires. Ces dispositifs sont répartis en rangées et en colonnes, formant les points mémoire, et reliés à des lignes de mot et de bit. Chaque dispositif de mémoire comporte une première électrode dite électrode commune et une deuxième électrode, les première et deuxième électrodes constituant suivant les polarisations appliquées des source ou drain de la structure de transistor MOSFET. La grille de commande de chaque dispositif de mémoire d'une même rangée est respectivement reliée à une même ligne de mot et la deuxième électrode de chaque dispositif de mémoire d'une même colonne est reliée à une même ligne de bit.
   Selon un procédé d'écriture d'informations dans un dispositif de mémoire sélectionné, d'un réseau de points mémoire tel que décrit ci-dessus, on applique un potentiel positif à toutes les électrodes communes, on applique un potentiel positif de sélection sur une ligne de mot correspondant au dispositif de mémoire sélectionné, et on applique un potentiel positif d'écriture sur la ligne de bit correspondant au dispositif de mémoire sélectionné.
   Selon un procédé de lecture d'informations dans un dispositif de mémoire sélectionné d'un réseau de points mémoire tel que décrit précédemment, on applique un potentiel sensiblement nul à toutes les électrodes communes, on applique un potentiel positif de sélection sur une ligne de mot correspondant au dispositif de mémoire sélectionné et on applique un potentiel positif de lecture sur la ligne de bit correspondant au dispositif de mémoire sélectionné, le potentiel de sélection appliqué à la ligne de mot étant supérieur à une valeur de seuil. La valeur de seuil est choisie suffisamment élevée pour permettre la lecture du point mémoire, mais toutefois suffisamment faible pour ne pas modifier la charge mémorisée dans le point mémoire ou dans les points mémoire voisins.
   Selon un procédé d'effacement d'informations dans un dispositif de mémoire sélectionné d'un réseau de points mémoire tel que décrit précédemment, on applique un potentiel sensiblement nul à toutes les électrodes communes, on applique un potentiel négatif d'effacement sur la ligne de mot correspondant au dispositif de mémoire sélectionné et on applique un potentiel positif de sélection sur la ligne de bit correspondant au dispositif de mémoire sélectionné.
   D'autres caractéristiques et avantages de la présente invention ressortiront mieux de la description qui va suivre, en référence aux figures des dessins annexés. Cette description est donnée à titre purement illustratif et non limitatif.

### Brève description des figures

- La figure 1 est une coupe schématique d'un dispositif de mémoire conforme à l'invention.
- La figure 2 est une courbe indiquant la charge stockée dans un dispositif de mémoire conforme à l'invention en fonction de la polarisation de la grille de commande de ce dispositif.
- La figure 3 est une courbe indiquant un courant drain-source en fonction de la tension de grille de commande du dispositif dans une phase d'écriture.
- La figure 4 est une courbe indiquant le courant de lecture d'un dispositif de mémoire conforme à l'invention, en fonction de la charge stockée.
- La figure 5 est une représentation schématique d'un réseau de points mémoire conforme à l'invention.
- Les figures 6, 7 et 8 sont des coupes schématiques d'un dispositif de mémoire conforme à l'invention lors de différentes étapes de son procédé de réalisation.

### Description détaillée de modes de mise en oeuvre particuliers de l'invention

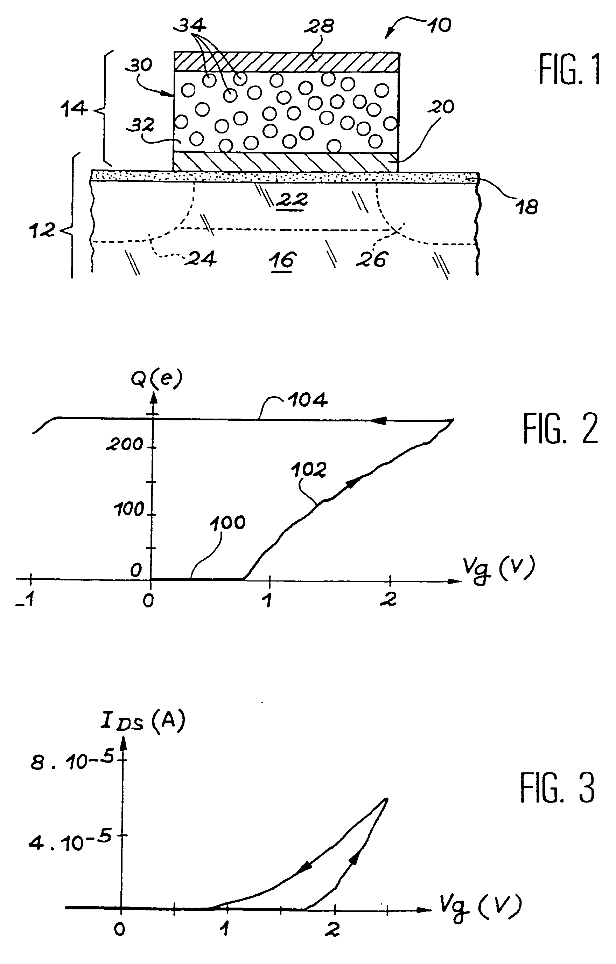

Le dispositif de mémoire 10 de la figure 1 comporte pour l'essentiel une structure 12 de transistor à effet de champ de type MOSFET (Metal Oxide Semiconductor Field Effect Transistor) à grille isolée, et un piège à.électrons 14.

La structure 12 de transistor MOSFET comprend un substrat semi-conducteur 16, en silicium, une couche de diélectrique 18, par exemple d'oxyde de grille en silice, et une première grille 20, dite grille flottante. Cette grille est en silicium polycristallin ou en métal.

Dans le substrat sont formés une région de canal 22, située pour l'essentiel sous la grille flottante 20 et des régions de drain 24 et de source 26 situées de part et d'autre du canal. On peut noter que la structure est symétrique et que les régions de drain et de source sont équivalentes.

Le piège à électrons 14, comporte la grille flottante 14 déjà mentionnée, une grille de commande 28 s'étendant parallèlement face à la grille flottante, et une structure 30 disposée entre la grille flottante et la grille de commande. La structure 30 comprend un diélectrique 32 et des îlots conducteurs 34.

Les îlots 34, en métal ou en un matériau semi-conducteur, constituent des sites sur lesquels peuvent être accumulées respectivement des charges de quelques porteurs (électrons ou trous).

La structure 30 est une structure à trois dimensions dans laquelle les îlots 34 sont uniformément répartis et mutuellement isolés par le diélectrique 32 qui les enrobe.

On indique ci-après, à titre d'exemple, des valeurs de paramètres pour le dispositif de la figure 1.
- longueur du canal : 50 nm,
- largeur du canal : 50 à 100 nm,
- épaisseur de l'oxyde de grille 18 : 3 à 5 nm,
- distance entre îlots 34 : 2 nm,
- dopage du canal : 2,5.10⁺¹⁸cm⁻², par exemple bore, indium, (impuretés acceptrices pour un canal de type N),
- tension source-drain de lecture : 0,5 volt.

La courbe de la figure 2, indique en fonction du potentiel V_{g}, exprimé en volts, appliqué à la grille de commande, la charge Q accumulée dans le piège à électrons et située dans la grille flottante. Le potentiel de grille V_{g} est mesuré par rapport à la source et la charge Q accumulée est exprimée en un multiple de la charge élémentaire d'un électron (ou trou) prise en valeur absolue.

On observe sur la partie 100 de la courbe que la charge accumulée, et donc mémorisée, est nulle pour des potentiels de grille inférieurs à 0,8 volt environ.

A partir de 0,8 volt, la charge accumulée augmente quasi-linéairement avec le potentiel appliqué à la grille de commande. Ceci correspond à la partie 102 de la courbe.

Enfin, la partie 104 montre que la charge accumulée est maintenue lorsque le potentiel appliqué à la grille diminue ou s'annule. La charge est maintenue jusqu'à une tension grille-source de l'ordre de -0,8 volt.

Ce phénomène d'hystérésis permet le stockage, c'est-à-dire la mémorisation, d'une charge proportionnelle à la tension initialement appliquée à la grille de commande. La charge est maintenue même après l'annulation de la tension de grille.

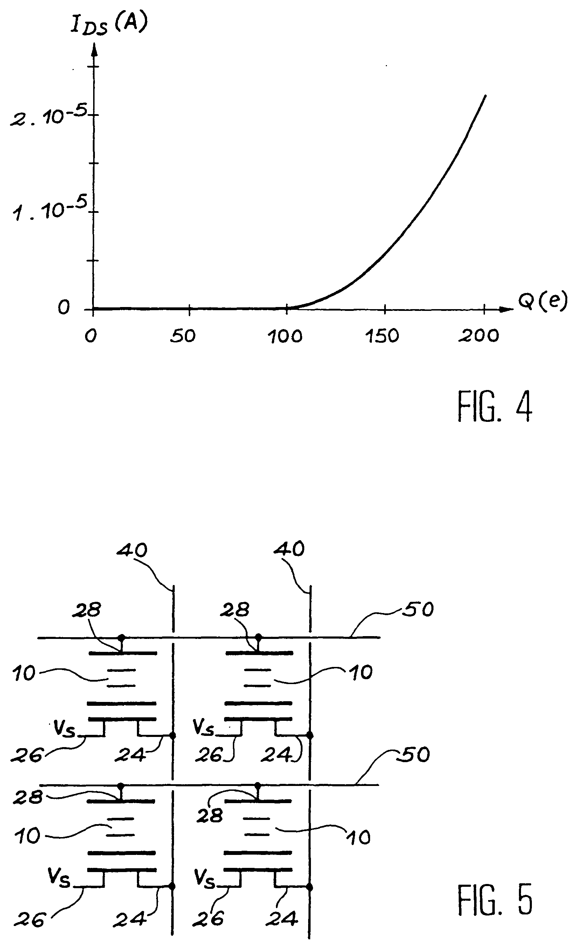

La courbe de la figure 3 indique la variation, correspondant à la figure 2, du courant drain-source I_{DS}, exprimé en ampère, en fonction du potentiel V_{g} appliqué à la grille de commande. Le potentiel V_{g} reporté en abscisse est exprimé en volt et est mesuré par rapport à la source.

La mesure du courant I_{DS} permet de contrôler la charge stockée dans la mémoire.

La courbe de la figure 4 indique un courant de lecture d'un dispositif de mémoire tel que décrit, en fonction de la charge stockée. La charge est reportée en abscisse et exprimée en multiple de la charge élémentaire et le courant est exprimé en Ampères. Les mesures sont effectuées avec des potentiels de grille de commande V_{g}, de drain V_{d} et de source Vₛ tels que V_{g}=2V, V_{d}=0,5V, Vₛ=0V.

On observe que pour des charges inférieures à 100e le courant de lecture est nul. Pour une charge de 200e ce courant atteint environ 20 µA.

La figure 5 montre un réseau de points mémoire utilisant des dispositifs de mémoire conformes à la figure 1. Les dispositifs, représentés très schématiquement, sont repérés avec la référence 10.

Pour des raisons de simplification, la figure 5 ne représente que quatre dispositifs de mémoire. Toutefois, un réseau conforme à cette figure peut comporter un grand nombre de dispositifs de mémoire.

Les dispositifs de mémoire sont agencés selon des rangées et des colonnes dans un réseau orthogonal.

Les grilles de commande 28 de tous les dispositifs 10 correspondant à une même rangée sont reliés à une même ligne 50, dite ligne de mot.

De la même façon, les drains 24 de tous les dispositifs 10 correspondant à une même colonne sont reliés à une même ligne 40, dite ligne de bit.

Les sources de tous les dispositifs de mémoire 10 sont interconnectées de façon à pouvoir leur appliquer un potentiel commun Vₛ.

Le tableau I ci-après indique, à titre d'illustration des valeurs du potentiel de sélection V_{g} appliqué aux grilles par les lignes de mot 50, du potentiel de lecture/écriture/effacement V_{d} appliqué aux drains par les lignes de bit 40 et le potentiel commun Vₛ appliqué aux sources, lors de phases d'écriture, de lecture et d'effacement.

**TABLEAU I**

| | Potentiel V_{g}/ ligne de mot | Potentiel V_{d/} ligne de bit | potentiel Vₛ/ source |
|---|---|---|---|
| ECRITURE | +2,5 V | 0 V | + 0,5 V |
| LECTURE | + 2 V | +0,5 V | 0 V |
| EFFACEMENT | -0,8 V | +0, 5 V | 0 V |

Les valeurs du tableau I correspondent aux potentiels appliqués aux dispositifs de mémoire sélectionnés.

Les valeurs du tableau II correspondent aux potentiels des lignes de bit et de mot autres que celles du dispositif de mémoire sélectionné.

**TABLEAU II**

| | LIGNES DE MOT | LIGNES DE BIT |
|---|---|---|
| ECRITURE | 0 V | 0,5 V |
| LECTURE | 0 V | 0V |
| EFFACEMENT | 0,5 V | 0 V |

On note que la tension appliquée à la ligne de mot du dispositif de mémoire sélectionné lors d'une phase de lecture est supérieure à la tension de seuil de conduction du transistor MOSFET pour permettre un niveau de courant de lecture suffisant sans perturber les charges mémorisées. Une valeur typique est 2V.

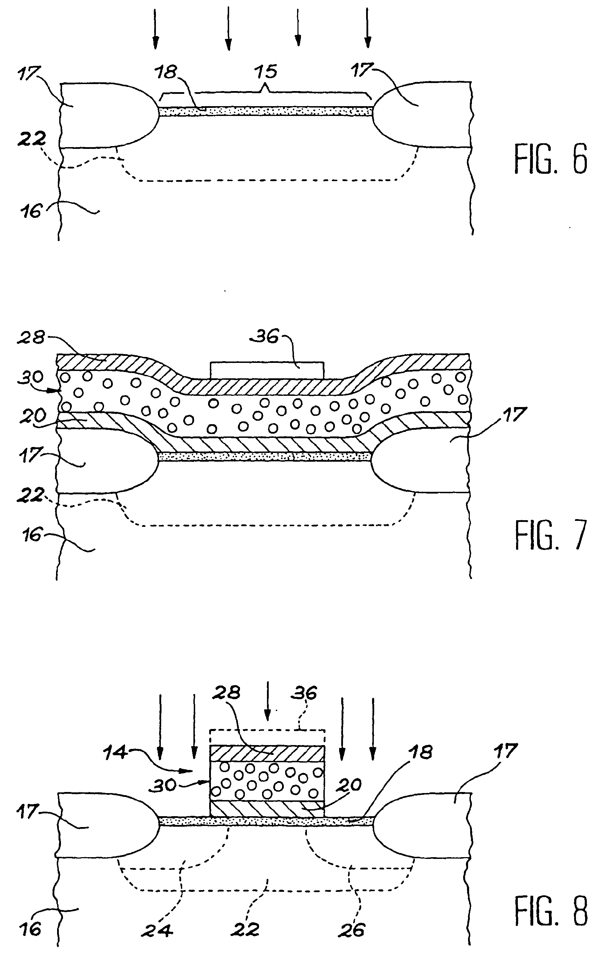

Les figures 6, 7 et 8, décrites ci-après, représentent les principales étapes de fabrication d'un dispositif de mémoire tel que décrit précédemment.

Ces figures et la description qui suit se réfèrent à la fabrication d'un seul dispositif de mémoire. Cependant, avec le même procédé de fabrication, il est possible de réaliser simultanément un grand nombre de dispositifs de mémoire sur un même substrat.

Dans une première étape représentée à la figue 6, on prépare un substrat 16 de façon à y délimiter une région 15 pour la fabrication du dispositif de mémoire. Dans l'exemple décrit, le substrat 16 est en silicium et ladite région 15 est délimitée par formation de pavés d'oxyde de champ épais 17. Ces pavés sont formés par exemple selon un procédé connu sous la désignation LOCOS (Local Oxidation of Silicon), ou STI (Shallow Trench Isolation).

Dans la région 15 on effectue une implantation d'ions de dopage, par exemple de bore ou indium pour former une région de canal 22 dans le substrat dans le cas d'un transistor MOSFET à canal N. L'implantation d'ions de dopage est représentée avec des flèches.

A la surface du substrat, entre les pavés 17 d'oxyde de champ, est formée une couche d'oxyde de grille avec une épaisseur de l'ordre de 3,5 nm ou plus. La fonction essentielle de cette couche est d'éviter un courant de décharge des charges mémorisées par effet tunnel.

Dans une étape ultérieure, représentée à la figure 7, on forme à la surface du substrat un empilement comportant dans l'ordre à partir de l'oxyde de grille une première couche de grille 20, une structure intermédiaire 30, isolante, comprenant des îlots conducteurs, et une deuxième couche de grille 28. Les première et deuxième couches dé grille sont par exemple en silicium polycristallin. Elles peuvent être dopées in-situ pour améliorer leur conductibilité électrique. Plusieurs possibilités sont offertes pour la réalisation de la structure intermédiaire 30.

Les îlots peuvent être métalliques, semi-conducteurs ou semi-métalliques (comme Sn).

La structure intermédiaire peut être réalisée par un dépôt d'un colloïde sous la forme de grains métalliques ou semi-conducteurs entourés par un polymère isolant permettant l'effet tunnel.

Une possibilité consiste à effectuer alternativement des dépôts de matériau isolant et de grains métalliques formant les îlots conducteurs. Pour la mise en oeuvre de ces dépôts, on peut se reporter au document (8) pour les dépôts métalliques dont la référence est indiquée à la fin de la présente description.

Une autre possibilité consiste à former alternativement des couches d'oxyde de silicium (SiO₂) isolantes et des couches d'oxyde de silicium (SiO₂) enrichies en Si, ou en Ge lors du dépôt, ou enrichis en Si, Ge ou en Sn, par implantation ionique.

Dans ce cas, un traitement thermique permet de former des nanocristaux à partir des atomes de Si, Ge ou Sn, et ainsi former les îlots conducteurs.

Pour la formation de nanocristaux on peut se reporter aux documents (9) et (10) dont les références sont indiquées à la fin de la présente description.

Une autre possibilité encore, consiste à former la structure 30 comprenant les îlots, par une alternance d'étapes de réalisation d'amas granulaires de silicium ou germanium et d'étapes d'oxydation. La réalisation d'amas de silicium peut avoir lieu, par exemple, par croissance par épitaxie de silicium sur des germes.

La référence 36 de la figure 7 indique un masque de gravure en résine formé sur l'empilement des couches. Ce masque définit les dimensions du piège à électrons à réaliser.

Comme le montrent les flèches sur la figure 8, les couches de grille 20 et 28 ainsi que la structure intermédiaire 30 sont soumises à une gravure, en utilisant le masque 36 comme masque de gravure. Cette gravure permet de définir le piège à électrons 14. La couche d'oxyde de grille peut être utilisée comme couche d'arrêt de gravure. La partie de cette couche dépassant du piège à électrons peut aussi être éliminée.

Le masque de gravure 36 est éliminé après la gravure et est ainsi représenté en trait discontinu sur la figure 8.

On peut noter que lors de la formation d'un réseau de plusieurs dispositifs de mémoire, la gravure de tous les pièges à électrons peut être simultanée.

Une implantation d'ions de dopage de type donneurs d'électrons pour un canal N, As ou P, avec une dose de l'ordre de quelques 10¹³at/cm² à quelques 10¹⁵at/cm², suivant la technologie de réalisation de transistors MOSFET, permet de former dans le substrat 16 des régions de drain 24 et de source 26 de part et d'autre de l'empilement mis en forme, c'est-à-dire de part et d'autre du piège à électrons.

Lors de cette implantation, l'empilement mis en forme sert de masque d'implantation. Ainsi, les régions de source et de drain sont auto-alignées sur le piège à électrons.

### DOCUMENTS CITES

***(1)*** K. Yano et al., "A room-temperature, single-electron memory device using fine-grain polycristalline silicon", IEEE International Electron Devices Meeting, pp. 541-544, 1993.
***(2)*** S. Tiwari et al. "Silicon nanocrystal based memory", Appl. Phys. Lett. 68(10), pp. 1377-1379, 1996.
***(3)*** K. Guo et al. "A room temperature silicon single-electron metal-oxide-semiconductor memory with nanoscale floating-gate and ultranarrow channel", Appl. Phys. Lett. 70(7), pp. 850-852, 1977.
***(4)*** A. Nakajima et al. "Room temperature operation of Si single-electron memory with self-aligned floating dot gate", Appl. Phys. Lett. 70(13), pp. 1742-1744, 1977.
***(5)*** K. Likharev, "Physics and possible applications of single-electron device", FED Journal, vol. 6, suppl. 1, pp. 5-14, 1995
***(6)*** V. Krupenin et al., Instability of single-electron memory at low temperature in Al/AlOx/Al structures", JETP 84(1), pp. 190-196, 1997.
***(7)*** K. Matsumoto et al., "Single electron memory on atomically flat α-Al₂O₃ substrate made by AFM nano-oxidation process", soumis à IEDM 1997.
***(8)*** H. Ahmed, "single atom scale lithography for single electron devices", Physica B 227, pp. 259-263, 1996.
***(9)*** H. Hanafi, et al. "Fast and long retentio-time nano-crystal memory", IEEE Trans. On Elec. Dev., vol. 43, N°9, pp. 1553-1558, 1996.
***(10)*** A. Nakajima et al., "Single electron charging of Sn nanocrystals in the thin SiO₂ film formed by low energy ion implantation", soumis à IEEE IEDM Conf. Decembre 1997.
***(11)*** D.J. DiMaria et al., "Electrically-alterable read-only-memory using Si-rich SiO₂ injectors and a floating polycrystalline silicon storage layer", 931 Jnal of Applied Physics, vol. 52 (1981), July, n° 7, New York, USA
***(12)*** EP-A-0 081 626

## Revendications

1. Dispositif de mémoire comprenant une structure de transistor MOSFET avec une grille flottante (20) et une grille de commande (28), dans laquelle la grille flottante (20) et la grille de commande (28) sont séparées uniquement par un diélectrique (32) incluant une pluralité d'îlots nanométriques conducteurs (34), séparés les uns des autres, les îlots nanométriques (34) formant une structure (30) tridimensionnelle d'îlots uniformément répartis dans tout le diélectrique entre la grille flottante (20) et la grille de commande (28).

2. Dispositif selon la revendication 1, dans lequel le diélectrique (32) comporte des couches superposées de matériau isolant électrique entre lesquels sont disposés des grains métalliques qui forment les îlots conducteurs (34).

3. Dispositif selon la revendication 1, dans lequel le diélectrique (32) comporte une alternance de couches de silice et de couches de silice comprenant des monocristaux de silicium ou de germanium, ces monocristaux formant les îlots conducteurs (34).

4. Dispositif selon la revendication 1, dans lequel la structure MOS comporte une couche d'oxyde de grille (18) avec une épaisseur supérieure ou égale à 3 nm.

5. Procédé de fabrication d'un dispositif de mémoire selon la revendication 1, comprenant les étapes suivantes :
a) formation dans un substrat (16) d'une région de canal (22),
b) formation d'une couche d'oxyde de grille .(18) s'étendant, au-dessus de la région de canal (22),
c) formation sur la couche d'oxyde de grille d'un empilement comportant dans l'ordre à partir de la couche d'oxyde de grille :
- une première couche de grille (28),
- une structure tridimensionnelle (30) d'îlots nanométriques conducteurs, uniformément répartis dans tout un diélectrique (32),
- une deuxième couche de grille (28), les première et deuxième couches de grille (28) étant séparées l'une de l'autre uniquement par ce diélectrique, incluant les ilots nanométriques conducteurs
d) mise en forme de l'empilement de couches par gravure en laissant subsister l'empilement au-dessus d'au moins une portion de la région de canal,
e) formation de régions (24, 26) de source et de drain auto-alignées sur l'empilement mis en forme.

6. Réseau de points mémoire comportant une pluralité de dispositifs de mémoire (10) selon la revendication 1, répartis en rangées et en colonnes, formant les points mémoire, et reliés à des lignes de mot et de bit (50, 40), chaque dispositif de mémoire comportant une première électrode (26) dite électrode commune et une deuxième électrode (24), les première et deuxième électrodes constituant suivant les polarisation appliquées les source ou drain de la structure de transistor MOSFET, la grille de commande de chaque dispositif d'une même rangée étant respectivement reliée à une même ligne de mot (50) et la deuxième électrode (24) de chaque dispositif d'une même colonne étant respectivement reliée à une ligne de bit (40).

7. Procédé d'écriture dans un dispositif de mémoire sélectionné d'un réseau de points mémoire selon la revendication 6, dans lequel on applique un potentiel positif à toutes les électrodes communes (26), on applique un potentiel positif de sélection sur une ligne de mot (50) correspondant au dispositif de mémoire sélectionné, et on applique un potentiel positif d'écriture sur la ligne de bit (40) correspondant au dispositif de mémoire sélectionné.

8. Procédé de lecture dans un dispositif de mémoire sélectionné d'un réseau de points mémoire selon la revendication 6, dans lequel on applique un potentiel sensiblement nul à toutes les électrodes communes (26), on applique un potentiel positif de sélection sur une ligne de mot (50) correspondant au dispositif de mémoire sélectionné et on applique un potentiel positif de lecture sur la ligne de bit (40) correspondant au dispositif de mémoire sélectionné, le potentiel de sélection appliqué à la ligne de mot (50) étant supérieur à une valeur de seuil.

9. Procédé d'effacement d'un dispositif de mémoire sélectionné d'un réseau de points mémoire selon la revendication 6, dans lequel on applique un potentiel sensiblement nul à toutes les électrodes communes (26), on applique un potentiel négatif d'effacement sur une ligne de mot (50) correspondant au dispositif de mémoire sélectionné et on applique un potentiel positif de sélection sur la ligne de bit (40) correspondant au dispositif de mémoire sélectionné.

## Claims

1. Memory device comprising a MOSFET transistor structure with a floating grid (20) and a control grid (28), in which the floating grid (20) and the control grid (28) are separated solely by a dielectric (32) comprising a plurality of nanometric conducting islands (34) separated from each other, the nanometric islands (34) forming a three dimensional structure (30) of islands uniformly distributed throughout the dielectric between the floating grid (20) and the control grid (28).

2. Device according to claim 1, in which the dielectric (32) comprises superposed layers of electricity insulating material between which metallic grains that form conducting islands (34) are located.

3. Device according to claim 1, in which the dielectric (32) comprises alternating layers of silicon and silicon layers comprising silicon or germanium single crystals, these single crystals forming conducting islands (34) .

4. Device according to claim 1, in which the MOS structure comprises a grid oxide layer (18) with a thickness equal to or greater than 3 nm.

5. Process for manufacturing a memory device according to claim 1, comprising the following steps:
a) formation of a channel region (22) in a substrate (16),
b) formation of a grid oxide layer (18) extending above the channel region (22),
c) formation of a stack on the grid oxide layer comprising the following in order starting from the grid oxide layer:
- a first grid layer (28),
- a three-dimensional structure (30) of nanometric conducting islands uniformly distributed throughout a dielectric (32),
- a second grid layer (28), the first and second grid layers (28) being separated from one another solely by the dielectric, including the nanometric conducting islands forming the memory dots,
d) shaping of the stack of layers by etching, allowing the stack to remain above at least one portion of the channel region,
e) formation of source and drain regions (24, 26) self-aligned on the shaped stack.

6. Network of memory dots comprising a plurality of memory devices (10) according to claim 1, distributed in rows and columns forming the memory dots and connected to word lines and bit lines (50, 40), each memory device comprising a first electrode (26) called the common electrode and a second electrode (24), the first and second electrodes forming sources or drains of the MOSFET transistor structure depending on the applied polarizations, the control grid for each device in a single row being connected to the same words line (50) and the second electrode (24) in each device in a single column being connected to the same bits line (40).

7. Process for writing in a memory device selected in a network of memory dots according to claim 6, in which a positive potential is applied to all common electrodes (26), a positive selection potential is applied to a words line (50) corresponding to the selected memory device, and a positive write potential is applied to the bits line (40) corresponding to the selected memory device.

8. Process for reading in a memory device selected in a network of memory dots such as that described in claim 6, in which an approximately zero potential is applied to all common electrodes (26), a positive selection potential is applied to a words line (50) corresponding to the selected memory device and a positive read potential is applied to the bits line (40) corresponding to the selected memory device, the selected potential applied to the words line (50) being greater than a threshold value.

9. Process for erasing a memory device selected in a memory dot network like that described in claim 6, in which an approximately zero potential is applied to all common electrodes (26), a negative erasing potential is applied to the words line (50) corresponding to the selected memory device, and a positive selection potential is applied to the bits line (40) corresponding to the selected memory device.

## Patentansprüche

1. Speichervorrichtung, eine MOSFET-Transistorstruktur mit einem schwebenden Gate (20) und einem Steuergate (28) umfassend, bei der das schwebende Gate (20) und das Steuergate (28) nur durch ein Dielektrikum (32) getrennt sind, das eine Vielzahl voneinander getrennter leitfähiger nanometrischer Inseln (34) umfasst, wobei die nanometrischen Inseln (34) eine dreidimensionale Struktur (30) gleichmäßig in dem gesamten Dielektrikum zwischen dem schwebenden Gate (20) und dem Steuergate (28) verteilter Inseln bildet.

2. Vorrichtung nach Anspruch 1, bei der das Dielektrikum (32) übereinanderliegende Schichten aus elektrisch isolierendem Material umfasst, zwischen denen Metallkörner angeordnet sind, die die leitfähigen Inseln (34) bilden.

3. Vorrichtung nach Anspruch 1, bei der das Dielektrikum (32) abwechselnd Siliciumdioxidschichten und Schichten aus Siliciumdioxid mit Monokristallen aus Silicium oder Germanium umfasst, wobei diese Monokristalle die leitfähigen Inseln (34) bilden.

4. Vorrichtung nach Anspruch 1, bei der die MOS-Struktur eine Gate-Oxid-Schicht (18) mit einer Dicke größer als oder gleich 3 nm umfasst.

5. Verfahren zur Herstellung einer Speichervorrichtung nach Anspruch 1, die folgenden Schritte umfassend:
a) Bildung eines Kanalbereichs (22) in einem Substrat (16),
b) Bildung einer Gate-Oxid-Schicht, die sich über dem Kanalbereich (22) erstreckt,
c) Bildung eines Stapels über der Gate-Oxid-Schicht, der ausgehend von der Gate-Oxid-Schicht in Reihenfolge umfasst:
- eine erste Gate-Schicht (20),
- eine dreidimensionale Struktur (30) mit gleichmäßig in einem Dielektrikum (32) verteilten leitfähigen nanometrischen Inseln,
- eine zweite Gate-Schicht (28), wobei die erste und die zweite Gate-Schicht nur durch dieses die leitfähigen nanometrischen Inseln enthaltende Dielektrikum voneinander getrennt sind,
d) Formung des Schichtenstapels durch Ätzung, wobei man den Stapel über wenigstens einem Teil des Kanalbereichs stehen lässt,
e) Bildung von auf den geformten Stapel selbstjustierten Source- und Drainbereichen (24, 26).

6. Speicherpunkteanordnung, eine Vielzahl von die Speicherpunkte bildenden Speichervorrichtungen (10) nach Anspruch 1 umfassend, zeilen- und spaltenförmig angeordnet und mit Wort- und Bitleitungen (50, 40) verbunden, wobei jede Speichervorrichtung eine Gemeinschaftselektrode genannte erste Elektrode (26) und eine zweite Elektrode (24) umfasst und die erste und die zweite Elektrode in Abhängigkeit von den angelegten Polarisationen bzw. Vorspannungen die Source oder den Drain der MOSFET-Transistorstruktur bildet, wobei das Steuergate jeder Vorrichtung einer selben Reihe jeweils mit einer selben Wortleitung (50) verbunden ist und die zweite Elektrode (24) jeder Vorrichtung einer selben Spalte jeweils mit einer Bitleitung (40) verbunden ist.

7. Verfahren zum Schreiben in eine selektierte Speichervorrichtung einer Speicherpunkteanordnung nach Anspruch 6, bei dem man ein positives Potential an alle Gemeinschaftselektroden (26) legt, ein positives Selektionspotential an eine der selektierten Speichervorrichtung entsprechende Wortleitung (50) legt, und ein positives Schreibpotential an die der selektierten Speichervorrichtung entsprechende Bitleitung (40) legt.

8. Verfahren zum Lesen einer selektierten Speichervorrichtung einer Speicherpunkteanordnung nach Anspruch 6, bei dem man ein im Wesentlichen null betragendes Potential an alle Gemeinschaftselektroden (26) legt, ein positives Selektionspotential an eine der selektierten Speichervorrichtung entsprechende Wortleitung (50) legt, und ein positives Lesepotential an die der selektierten Speichervorrichtung entsprechende Bitleitung (40) legt, wobei das an die Wortleitung (50) gelegte Selektionspotential höher ist als ein Schwelienwert.

9. Verfahren zum Löschen einer aus einer Speicherpunkteanordnung nach Anspruch 6 selektierten Speichervorrichtung, bei dem man ein im Wesentlichen null betragendes Potential an alle Gemeinschaftselektroden (26) legt, ein negatives Löschpotential an eine der selektierten Speichervorrichtung entsprechende Wortleitung (50) legt, und ein positives Selektionspotential an die der selektierten Speichervorrichtung entsprechende Bitleitung (40) legt.
